# EUROPÄISCHE PATENTSCHRIFT

(11) **EP 1 302 094 B1**
(45) Veröffentlichungstag und Bekanntmachung des Hinweises auf die Patenterteilung: **03.12.2008**
(21) Anmeldenummer: 01967199.9
(22) Anmeldetag: 18.07.2001
(51) Int. Cl.: H05K 3/36, H01R 12/38

(54) **VERFAHREN ZUR HERSTELLUNG EINER ELEKTRISCHEN UND/ODER MECHANISCHEN VERBINDUNG VON FLEXIBLEN DÜNNFILMSUBSTRATEN**
METHOD FOR PRODUCING AN ELECTRICAL AND/OR MECHANICAL CONNECTION BETWEEN FLEXIBLE THIN-FILM SUBSTRATES
PROCEDE DE REALISATION D'UN RACCORDEMENT ELECTRIQUE ET/OU MECANIQUE ENTRE DES SUBSTRATS A COUCHES MINCES SOUPLES

(30) Priorität: 19.07.2000 DE 10035175
(43) Veröffentlichungstag der Anmeldung: 16.04.2003
(73) Patentinhaber: Fraunhofer-Gesellschaft zur Förderung der angewandten Forschung e.V., 80686 München (DE)
(72) Erfinder: HABERER, Werner, 66386 St. Ingbert (DE); SCHÜTTLER, Martin, 66111 Saarbrücken (DE); BEUTEL, Hans-Jörg, 72269 Unterensingen (DE)
(74) Vertreter: Rösler, Uwe
(86) Internationale Anmeldenummer: PCT/EP2001/008268
(87) Internationale Veröffentlichungsnummer: WO 2002/007486

(56) Entgegenhaltungen:
- EP-A- 0 561 620
- DE-A- 3 512 237
- DE-A- 3 703 694
- DE-A- 4 131 413
- DE-A- 19 831 876
- GB-A- 737 998
- GB-A- 1 142 160
- US-A- 3 446 908
- US-A- 6 013 876

## Beschreibung

### Technisches Gebiet

Die Erfindung bezieht sich auf ein Verfahren zur Herstellung einer elektrischen und/oder mechanischen Verbindung zwischen wenigstens zwei flexiblen Dünnfilmsubstraten, sowie auf eine diesbezügliche Kontaktanordnung.

### Stand der Technik

Dünnfilmsubstrate oder umgangssprachlich auch als Flexsubstrate bezeichnet, stellen flexible Foliensubstrate dar, die zumeist aus einem organischen Flächenmaterial bestehen und flächig aufgebrachte elektrische Leiterstrukturen vorsehen, auf denen häufig elektrische Bauelemente aufgesetzt sind. Insbesondere in der Mikroelektronik finden in geeigneter Weise derartig prozessierte Flexsubstrate, deren Substratdicke lediglich ca. 10 µm beträgt, zur elektrischen und mechanischen Verbindung elektronischer Bauteile vielfältige Anwendungen. Die Herstellung dieser mechanischen sowie elektrisch leitenden Verbindungen erfolgt üblicherweise mit einem Verfahren, das allgemein als "Bonden" bezeichnet wird. Zur Technik des Bondens sei auf die Druckschrift DE 198 31 876 A1 verwiesen, auf die im übrigen bezüglich der in dieser Schrift verwendeten Fachterminologie Bezug genommen wird. Auch gehen aus der DE 37 03 694 A1 genauere Einzelheiten zum sogenannten Ball-Bondverfahren hervor. In diesem Zusammenhang beschäftigt sich auch die DE 41 31 413 A1, in der ein auf dem Ball-Bondverfahren beruhendes Bondierungsverfahren für Halbleiterchips beschrieben ist und die Herstellung von turmartigen Verbindungsstrukturen zum Gegenstand hat.

Neben der Verbindung mikroelektronischer Bauelemente auf mit Leiterstrukturen prozessierten Flexsubstraten werden insbesondere im Bereich der Aufbau- und Verbindungstechnik (AVT) für die Ausbildung hochkomplexer Mikrosysteme häufig zwei oder mehrere Flexsubstrate miteinander verbunden. Dies erfolgt nach heutigem Stand der Technik mittels Kleben, Löten, Schweißen oder Thermokompressionsbonden.

Beim Verkleben wenigstens zweier Flexsubstrate miteinander bedient man sich leitfähiger Klebemittel in Form von elektrisch leitfähigen Polymeren, die an bestimmten Stellen der miteinander zu verbindenden Flexsubstrate aufgebracht werden. Beim Kontaktieren der miteinander zu verbindenden Flexsubstrate zeigt sich jedoch aufgrund der zwischen den Substraten auftretenden Kapillarkräfte ein nur schlecht kontrollierbarer Kriechvorgang des zähflüssigen Klebstoffes. Sollen dennoch Flexsubstrate mit filigran ausgebildeten Leiterstrukturen mit Hilfe der Klebetechnik verbunden werden, so bedarf es aufwendige verfahrenstechnische Massnahmen, die unvermeidbar mit hohen Kosten verbunden sind.

Das Verfügen zweier Flexsubstrate mittels bekannter Löttechniken erlaubt hingegen lediglich die Herstellung einer elektrischen Verbindung, zumal auf den Oberflächen der Flexsubstrate aufgebrachte Metallisierungen in Form elektrischer Leiterstrukturen vorhanden sein müssen, um Lötverbindungen zwischen zwei Flexsubstraten herzustellen. Infolgedessen ist es nicht möglich Flexsubstrate mit aus elektrisch leitfähigen Polymeren bestehenden elektrischen Leiterstrukturen mit an sich bekannten Löttechniken untereinander zu verfügen. Darüber hinaus eignet sich Löten aufgrund der Lötmaterialien sowie deren Prozessprodukte nicht für den Einsatz im medizinischen Bereich, da hier die Forderung nach ausschließlicher Verwendung biokompatibler Materialien besteht.

Mit den bisher bekannten Schweißtechniken ist es derzeit nicht möglich, in einem einzigen Prozess sowohl eine mechanische Verbindung als auch eine elektrische Kontaktierung herbeizuführen. So sind bei den üblicherweise eingesetzten Materialien beim Verbinden zweier Flexsubstraten zumindest zwei unterschiedliche Fügeschritte erforderlich, bei denen zum einen die Technik des Kunststoffverschweißens und zum anderen die Technik des Metallverschweißens einzusetzen ist. Das Metallisierungsverschweißen setzt darüber hinaus eine gewisse Mindestdicke der leitfähigen Schicht voraus, die für gewöhnlich das Vielfache der Dicke einer Dünnfilmsubstratmetallisierung, wie sie durch Sputtern oder Aufdampfen erzeugt wird, beträgt.

In diesem Zusammenhang geht aus der DE 35 12 237 A1 ein Verbindungsverfahren für die Herstellung einer mehrschichtigen flexiblen Schaltungsanordnung hervor, bei dem zwei benachbarte Schaltungsträgerschichten mittels Ultraschallschweißung miteinander verfügt werden. Zur Fügetechnik des Ultraschallschweißens sind die vorstehenden Nachteile zu nennen.

Schließlich ist ähnlich wie bei Löttechniken die Technik des Thermokompressionsbondens auf eine Metallisierungsschicht angewiesen, so dass die Herstellung einer rein mechanischen Verbindung von Flexsubstrat, die für gewöhnlich aus organischen Materialien bestehen, mittels Thermokompressionsbonden nicht möglich ist.

### Darstellung der Erfindung

Der Erfindung liegt die Aufgabe zugrunde, ein Verfahren zur Herstellung einer elektrischen und/oder mechanischen Verbindung zwischen wenigstens zwei flexiblen Dünnfilmsubstraten bzw. Flexsubstraten sowie eine diesbezügliche Kontaktanordnung derart auszubilden, dass die zu den vorstehend genannten bekannten Fügetechniken aufgezeigten Nachteile überwunden werden können. Insbesondere sollen wenigstens zwei Flexsubstrate in einer räumlich präzisen Anordnung verfügbar sein. Die hierfür einzusetzenden Fügematerialien sollen biokompatibel sein, so dass ein Einsatz auch in medizinischen Bereichen möglich wird. Die Fügetechnik soll ferner unabhängig von der Präsenz von Metallisierungsschichten anwendbar sein, so dass auch ein bloßes mechanisches Verfügen wenigstens zweier Flexsubstrate miteinander möglich wird. Das erfindungsgemäße Verfahren bzw. die Kontaktanordnung soll einfach in der Herstellung und nur geringe Verfahrenskosten aufwerfen.

Die Lösung der der Erfindung zugrundeliegenden Aufgabe ist im Anspruch 1 angegeben. Gegenstand des Anspruches 9 ist eine Kontaktanordnung, die mit dem erfindungsgemäßen Verfahren herstellbar ist. Vorteilhafte Merkmale, die den Erfindungsgedanken weiterbilden, sind Gegenstand der Unteransprüche sowie der Beschreibung unter Bezugnahme auf die Figuren zu entnehmen.

Erfindungsgemäß ist ein Verfahren zur Herstellung einer elektrischen und/oder mechanischen Verbindung zwischen wenigstens zwei flexiblen Dünnfilmsubstraten dadurch ausgebildet, dass die zu verbindenden Flexsubstrate, die an einer Verbindungsstelle jeweils wenigstens eine Öffnung aufweisen, derart positioniert werden, dass die Öffnung des einen Flexsubstrates deckungsgleich mit der Öffnung des anderen Flexsubstrates zu liegen kommt. Typischerweise weisen die Öffnungen an den gewünschten Verbindungsstellen Öffnungsdurchmesser von etwa 50 µm auf, so dass bereits durch eine präzise Justierung zweier oder mehrerer zu verbindender Flexsubstrate unter Maßgabe der in Deckung zu bringenden Öffnungen eine höchst exakte, gegenseitige Ausrichtung der einzelnen Flexsubstrate möglich ist. Beidseitig an die deckungsgleich ausgerichteten Öffnungen werden jeweils ein Bondelement positioniert, die anschließend gegeneinander druckbeaufschlagt zu einer Bondverbindung verfügt werden, wobei die den Bondelementen jeweils zugewandten Umfangsränder der Öffnungen wenigstens teilweise von den durch den Bondvorgang verformten Bondelementen umschlossen werden. Üblicherweise erfolgt der Bondvorgang mit Hilfe einer Bond-Kapillare, die jeweils ein Bondelement in Form eines Bond-Balls zur Verfügung stellt und die Bondverbindung druckbeaufschlagt unter Zufuhr thermischer und von Ultraschall-Energie zu einem sogenannten Bond-Bump verformt.
Mit dem erfindungsgemäßen Verfahren ist es möglich, zwei oder mehrere Flexsubstrate vertikal übereinander zu verbinden, wobei der Einsatz biokompatibler Werkstoffe, beispielsweise unter Verwendung von Gold-Bump-Elementen, möglich ist.

Befinden sich die Öffnungen innerhalb der jeweils miteinander zu verbindenden Flexsubstrate in Bereichen, in denen keine elektrisch leitfähigen Leiterstrukturen vorgesehen sind, so vermag die mit dem erfindungsgemäßen Verfahren hergestellte Bondverbindung die Flexsubstrate lediglich mechanisch fest aneinander zu fügen. Sind jedoch die Flexsubstrate im Bereich der Öffnungen mit einer elektrisch leitfähigen Schicht ausgestattet, so werden diese Schichten elektrisch durch das elektrisch leitfähige Bondmaterial miteinander verbunden.

Zum Verbinden zweier oder mehrerer Flexsubstrate bedarf es wenigstens zweier Bondelemente, die durch die Öffnungen der miteinander in Deckung gebrachten Flexsubstrate hindurch miteinander zu einer innigen Bondverbindung verfügt werden. Zum einen kann das Bereitstellen der beiden Bondelemente jeweils durch eine Bondkapillare erfolgen, wobei es für die gleichzeitige Verarbeitung zweier Bondelemente zweier Bondkapillaren bedarf, die den Öffnungen der in Deckung gebrachten, miteinander zu verfügenden Flexsubstraten gegenüberliegend angeordnet werden, um unter Druckbeaufschlagung sowie Zufuhr thermischer und Ultraschall-Energie die Bondelemente an den Öffnungen miteinander zu verfügen.

Eine andere Möglichkeit zur Herstellung der erfindungsgemäßen Kontaktanordnung sieht vor, dass ein Bondelement zunächst auf ein Hilfssubstrat, das beheizbar ist, mit Hilfe einer Bondkapillare aufgebracht wird und zu einem Bond-Bump verformt wird. Anschließend werden die miteinander zu verfügenden Flexsubstrate deckungsgleich mit ihren Öffnungen über das auf dem Hilfssubstrat aufliegende Bond-Bump positioniert. Abschließend wird vertikal von oben ein weiterer Bondball auf die Öffnungen der übereinandergestapelten Flexsubstrate mit Hilfe der Bondkapillare aufgesetzt und mit dem auf dem Hilfssubstrat aufliegenden Bond-Bump unter thermischer und Ultraschall-Energiezufuhr verfügt. Optional ist es möglich, dass bei Abführen der Bond-Kapillare eine Verbindungsleitung zum obersten Bondelement bzw. Bond-Ball verbleibt.

Die obenstehend beschriebenen Techniken sind je nach Größe der Öffnungen sowie Durchmesser der verwendeten Bondelemente bzw. Bond-Bälle auch für das gegenseitige Verfügen von drei und mehr Flexsubstraten geeignet. Selbstverständlich ist es möglich, die vorstehend beschriebene Vorgehensweise auch derart anzuwenden, dass jeweils ein bereits verfügtes Flexsubstratpaar mit einem weiteren bereits verfügten Flexsubstratpaar über entsprechende Bondverbindungen miteinander zu einer Stack-Anordnung verfügt werden können.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnung exemplarisch beschrieben. Es zeigen:
- Fig. 1a,b: Darstellung eines an sich bekannten Flexsubstrates,
- Fig. 2a -h: Verfahrensschritte zur Herstellung einer Bondverbindung Zwischen zwei Flexsubstraten,
- Fig. 3: Verfahrensschritte zur Herstellung einer Verbindung von mehr als zwei Flexsubstraten,
- Fig. 4a-d: Verfahrensschritte zur Herstellung eines turmartigen Kontaktfingers mit Hilfe von übereinander verfügter Bondelemente,
- Fig. 5a-d: Verfahrensschritte zur Herstellung einer Bondverbindung mit unmittelbar daran verbundener elektrischer Zuleitung.

### Wege zur Ausführung der Erfindung, gewerbliche Verwendbarkeit

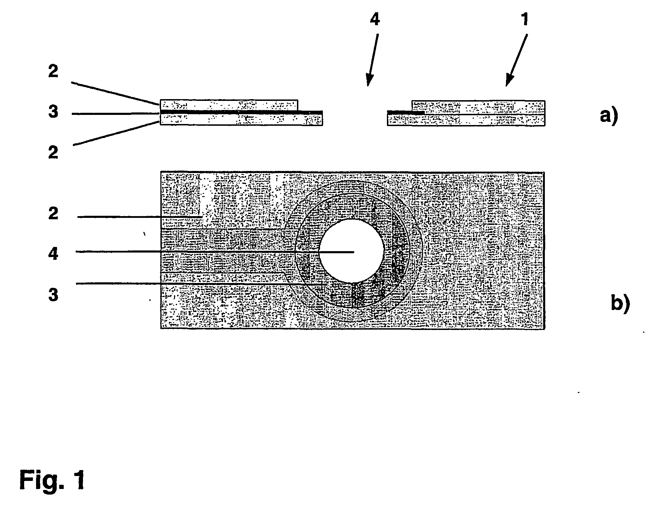

In Fig. 1 ist in Abbildung 1 a die Seitendarstellung eines schematischen Aufbaus eines Flexsubstrates 1 dargestellt, das aus zwei elektrisch isolierenden Schichten 2 sowie einer, zwischen den elektrisch isolierenden Schichten 2 befindlichen elektrisch leitfähigen Schicht 3 besteht. Der Schichtaufbau des Flexsubstrates 1 weist eine Dicke typischerweise von wenigen 10 µm auf. Ferner ist eine Öffnung 4 vorgesehen, die das Flexsubstrat 1 derart durchsetzt, dass sie einerseits von der elektrisch leitfähigen Schicht 3 vollständig umgeben ist und andererseits beide elektrisch isolierenden Schichten 2 vollständig durchsetzt. Die obere elektrisch isolierende Schicht 2 ist von der Öffnung 4 beabstandet angeordnet, so dass sich um die Öffnung 4 ein nach oben hin frei zugänglicher Umfangsrand ausbildet, der für eine spätere Kontaktierung von großer Bedeutung ist. Fig. 1b zeigt eine Draufsicht auf das in Fig. 1 a dargestellte Flexsubstrat 1.

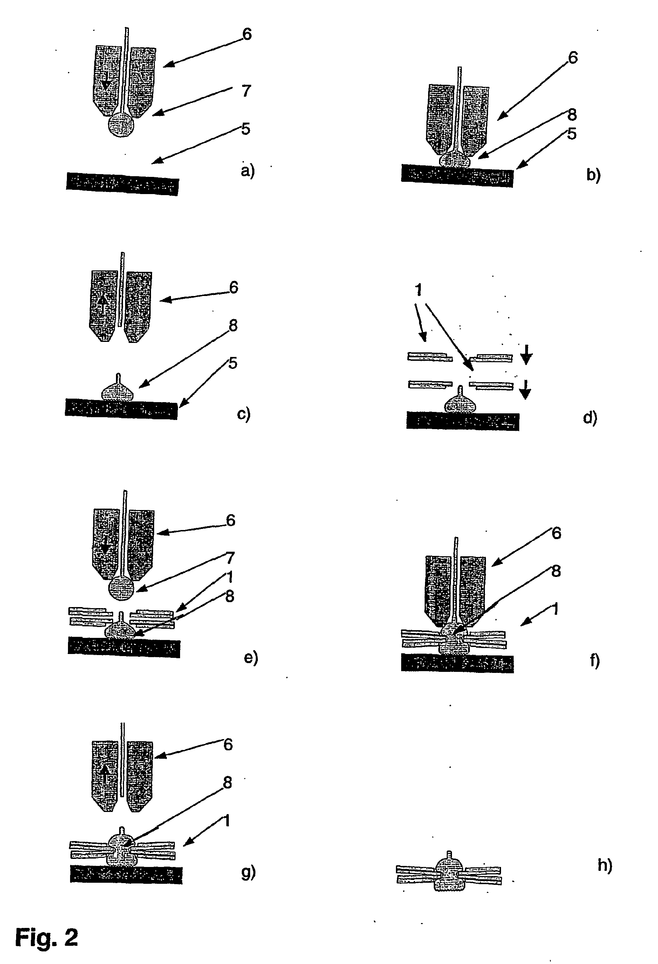

In Fig. 2 sind in Teildarstellungen a bis h Verfahrensschritte dargestellt, nach denen die Herstellung einer erfindungsgemäßen elektrisch und mechanischen Verbindung zweier Flexsubstrate erfolgt. Zunächst wird gemäß Fig. 2a auf einem Hilfssubstrat 5, das vorzugsweise beheizbar ist, mit Hilfe einer Bond-Kapillare 6, die vorzugsweise als Ball-Wedge-Bonder ausgebildet ist, ein Bond-Ball 7 aufgebracht. Die Bond-Kapillare 6 ist mit einer Ultraschallwellen erzeugenden Einheit verbunden. Durch einen Hohlkanal innerhalb der Bond-Kapillare 6 wird ein elektrisch leitfähiges Material, vorzugsweise Metall, in Form eines Drahtes an die Spitze der Bond-Kapillare 6 gefördert, an der das Bondmaterial durch Zufuhr thermischer Energie, bspw. durch Funkenentladung, zu einem Ball 7 aufschmilzt. Im nächsten Verfahrensschritt gemäß Fig. 2b wird der an der Spitze der Bond-Kapillare 6 ausgebildete Bond-Ball 7 gegen das Hilfssubstrat 5 unter Zufuhr von Ultraschallenergie, die über die Bond-Kapillare 6 auf den Bond-Ball 7 einwirkt, kraftbeaufschlagt gedrückt. Hierdurch wird der Bond-Ball 7 zu einem Bond-Bump 8 verformt.

Im Verfahrensschritt gemäß Fig. 2c wird die Bond-Kapillare 6 zurückgeführt, wobei die Drahtzuführung vom Bond-Bump 8 abgerissen wird. Lediglich der Bond-Bump 8 verbleibt auf dem Hilfssubstrat 5 zurück. Im weiteren Schritt gemäß Fig. 2d werden die miteinander zu verbindenden Flexsubstrate 1 über den auf dem Hilfssubstrat 5 aufgebrachten Bond-Bump 8 mit jeweils ihren Öffnungen 4 zentriert und arretiert. Gemäß Fig. 2e erfolgt nun abermals ein Zuführen eines Bond-Balls 7 auf die übereinander gestapelten Flexsubstrate 1. Gemäß Fig. 2f erfolgt ein Aufbonden des zweiten Bond-Bumps 8 auf den ersten, unmittelbar auf dem Hilfssubstrat 5 aufliegenden Bond-Bumps 8 derart, so dass die zwischen beiden Bond-Bumps befindlichen Flexsubstrate 1 gegeneinander fest verfügt werden. Nach erfolgtem Aufbonden wird die Bond-Kapillare 6 gemäß Fig. 2g zurückgeführt, wobei der Bonddraht von dem oberen Bond-Bump abgerissen wird. Schließlich wird der untere Bond-Bump vom Hilfssubstrat 5 mechanisch entfernt. Als Ergebnis verbleibt eine innige mechanische und elektrische Verbindung zwischen den Flexsubstraten 1 gemäß Fig. 2 h.

Die mit diesem Verfahren hergestellte Kontaktanordnung zeichnet sich insbesondere durch zwei gegeneinander gefügte Bond-Bumps 8 aus, die im verformten, gebondeten Zustand die Umfangsränder der Öffnungen beider miteinander verbundenen Flexsubstrate umschließen. Auf diese Weise werden die Flexsubstrate an der Verbindungsstelle zu einer festen elektrischen innigen Verbindung zusammengefügt.

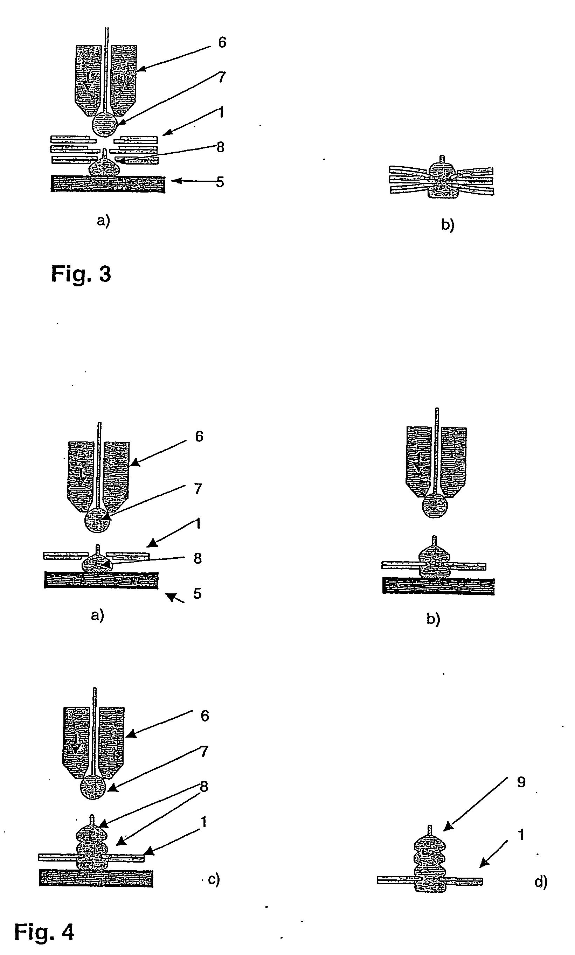

Auch ist es möglich, mehr als zwei Flexsubstrate mit Hilfe zweier Bond-Bumps miteinander zu verfügen, wie es insbesondere aus den Fig. 3a und b hervorgeht. Wieder sind die miteinander zu verfügenden Flexsubstrate 1 mit ihren jeweiligen Öffnungen gegenseitig überdeckend relativ zum ersten Bond-Bump 8 zentriert anzuordnen und entsprechend zu arretieren. Anschließend erfolgt gemäß dem Bondvorgang der Fig. 2e ein Aufbringen des Bond-Balls 7 mit Hilfe der Bond-Kapillare 6, gemäß Darstellung in Fig. 3a. Nach entsprechender Kraftbeaufschlagung sowie Zufuhr von thermischer sowie Ultraschall-Energie sind beide Bond-Bumps 8 miteinander verfügt und bilden eine Bondverbindung gemäß Fig. 3b nachdem die Bond-Kapillare 6 zurückgeführt und der Bonddraht abgerissen worden ist.

In den Fig. 4a bis d ist eine vorteilhafte Verfahrensvariante dargestellt, mit der ein dreidimensionales Multielektroden-Array bestehend aus einzelnen Kontaktfingern, hergestellt werden kann. So ist gemäß Fig. 4a auf einem Hilfssubstrat 5 ein Bond-Bump 8 angebracht, der mit der in den Fig. 2a bis c dargestellten Verfahrensweise gewonnen werden kann. Auf dem Bond-Bump 8 ist ein Flexsubstrat 1 entsprechend seiner Öffnung 4 zentriert angeordnet und wird mit Hilfe einer Bond-Kapillare 6 mit einem weiteren Bond-Ball 7 beaufschlagt. In Fig. 4b sind die zwei miteinander verfügten Bond-Bumps 8 dargestellt. Auf die Bondverbindung wird nun ein weiterer Bond-Ball 7 mit der Bond-Kapillare 6 gemäß Fig. 4b zugeführt sowie in gleicher Weise abermals ein weiterer Bond-Ball 7 gemäß Fig. 4c. Als Endresultat wird eine Turmstruktur 9 erhalten, die aus einer Vielzahl von übereinander angeordneten Bond-Bumps 8 besteht. Eine derartige Turmstruktur 9 kann beispielsweise als penetrierende Nervenelektrode im Medizin oder Biologiebereich eingesetzt werden. Mehrere Turmstrukturen, die auf einem Substrat aufgebracht sind, ergeben ein dreidimensionales Multielektroden-Array, das beispielsweise zur Ankopplung von kortikalem Nervengewebe Anwendung finden kann.

Ebenso ist es möglich, mit Hilfe der Turmstrukturen 9 unterschiedliche Flexsubstrate in unterschiedlichen Abständen voneinander fest miteinander zu verfügen. Hierbei dienen einzelne Bond-Bumps, die unmittelbar miteinander verfügt werden können, als Abstandshalter.

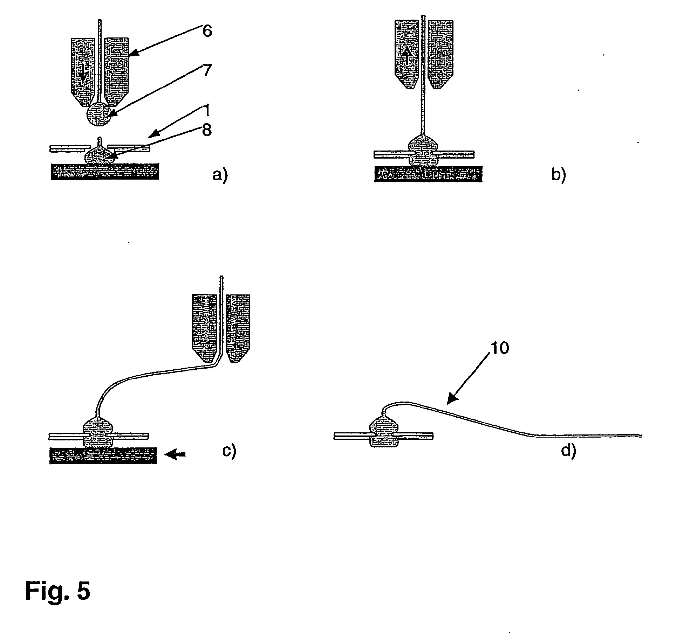

In den Fig. 5a bis d ist gezeigt, wie eine Bondverbindung, bestehend aus zwei Bond-Bumps 8 mit einer elektrischen Zuführleitung 10 verbunden werden kann. Im Gegensatz zu den vorstehenden Verfahrensvarianten, bei denen beim Zurückführen der Bond-Kapillare 6 zugleich auch der Bonddraht abgerissen wird, erfolgt gemäß Verfahrensvariante der Fig. 5b das Zurückführen der Bond-Kapillare 6 ohne ein entsprechendes Abreißen des Bonddrahtes. Durch entsprechendes seitliches Verschwenken der Bond-Kapillare 6 relativ zum Hilfssubstrat 5 bzw. ein seitliches Verfahren des Hilfssubstrates 5 gegenüber der Bond-Kapillare 6 wird der mit dem obersten Bond-Bump verbundene Bonddraht 10 seitlich verformt und kann als elektrische Zuführleitung gemäß Fig. 5d dienen.

Die vorstehend beschriebene erfindungsgemäße Verfahrensweise zur Herstellung einer elektrischen und/oder mechanischen Verbindung zwischen wenigstens zwei flexiblen Dünnfilmsubstraten findet besondere Anwendung bei der Prototypen- und Kleinserienfertigung von Elektroniken auf flexiblen Substraten. Besonders interessante technische Bereiche hierfür stellen die Militärtechnik sowie die Raumfahrttechnik dar. Als Besonderheit sei nochmals auf die Biokompatibilität verwiesen, sofern alle eingesetzten Materialien einschließlich des Bondmaterials aus biokompatiblem Material bestehen. Dies macht es insbesondere möglich, die mit der erfindungsgemäßen Kontaktanordnung ausgebildeten Flexsubstrate in der Medizintechnik, besonders im Bereich elektronischer Implantate, zu verwenden.

### Bezugszeichenliste

- 1: Flexsubstrat
- 2: elektrisch isolierende Schicht
- 3: elektrisch leitfähige Schicht
- 4: Öffnung
- 5: Hilfssubstrat
- 6: Bond-Kapillare
- 7: Bond-Ball
- 8: Bond-Bump
- 9: Turmstruktur
- 10: Bonddraht

## Patentansprüche

1. Verfahren zur Herstellung einer elektrischen und/oder mechanischen Verbindung zwischen wenigstens zwei flexiblen Dünnfilmsubstraten, im folgenden Flexsubstrate (1),
**dadurch gekennzeichnet, dass** die zu verbindenden Flexsubstrate, die an einer Verbindungsstelle jeweils wenigstens eine Öffnung (4) aufweisen, derart positioniert werden, dass die Öffnung (4) des einen Flexsubstrates deckungsgleich ist mit der Öffnung (4) des anderen Flexsubstrates,
dass beidseitig an die deckungsgleich ausgerichteten Öffnungen (4) jeweils ein Bondelement (7) positioniert wird, und
dass beide Bondelemente (7) gegeneinander druckbeaufschlagt, die den Bondelementen (7) jeweils zugewandten Umfangsränder der Öffnungen (4) wenigstens teilweise umschließend, zu einer Bondverbindung verfügt werden.

2. Verfahren nach Anspruch 1,
**dadurch gekennzeichnet, dass** die Bondelemente in Form eines Bond-Balls (7) von einer Bond-Kapillare (6), bspw. von einem Ball-Wedge-Bonder, bereitgestellt werden.

3. Verfahren nach Anspruch 1 oder 2,
**dadurch gekennzeichnet, dass** ein erstes Bondelement (7) auf ein Hilfssubstrat (5) aufgebracht wird.

4. Verfahren nach Anspruch 3,
**dadurch gekennzeichnet, dass** das Hilfssubstrat (5) geheizt und das Bondelement (7) auf das Hilfssubstrat (5) aufgepresst und unter Zufuhr von Ultraschallenergie zu einem Bond-Bump (8) verformt wird.

5. Verfahren nach Anspruch 3 oder 4,
**dadurch gekennzeichnet, dass** die zueinander deckungsgleich ausgerichteten Öffnungen (4) der zu verbindenden Flexsubstrate (1) über das erste Bondelement (7) positioniert werden,
dass ein zweites Bondelement (7) durch die Öffnungen (4) gegen das, auf dem Hilfssubstrat (5) aufliegende erste Bondelement (7) kraftbeaufschlagt sowie unter Hitze- und Ultraschallenergiezufuhr verfügt wird, und
dass nach Verfügung das Hilfssubstrat (5) entfernt wird.

6. Verfahren nach Anspruch 5,
**dadurch gekennzeichnet, dass** vor Entfernen des Hilfssubstrats (5) wenigstens ein weiteres Flexsubstrat (1) mit den bereits verfügten Flexsubstraten (1) verbunden wird, indem die Öffnung (4) des weiteren Flexsubstrats (1) über das zweite Bondelement (7) positioniert und mittels eines dritten Bondelementes (7) durch die Öffnung (4) des weiteren Flexsubstrates (1) gegen das zweite Bondelement (7) verfügt wird.

7. Verfahren nach Anspruch 6,
**dadurch gekennzeichnet, dass** der Vorgang zum Erhalt einer turmartigen Anordnung (9), einer sogenannten Stackanordnung, von einer Vielzahl miteinander verbundener Flexsubstrate (1) wiederholt wird.

8. Verfahren nach einem der Ansprüche 1 bis 7,
**dadurch gekennzeichnet, dass** in den Flexsubstraten (1) elektrisch leitende Schichten (3) vorgesehen sind,
dass zur Verbindung der elektrisch leitenden Schichten (3) zwischen zwei Flexsubstraten (1) die Öffnungen (4) derart in die Flexsubstrate (1) eingebracht werden, dass die elektrisch leitenden Schichten (3) an den Umfangsränder der Öffnungen (4) enden, sodass die Bondverbindung durch die Öffnungen (4) hindurch einen elektrischen Kontakt zwischen den elektrisch leitenden Schichten (3) unmittelbar benachbarter Flexsubstrate (1) herstellen.

9. Kontaktanordnung zwischen wenigstens zwei flexiblen Dünnfilmsubstraten, im folgenden Flexsubstrate (1),
**dadurch gekennzeichnet, dass** die Flexsubstrate (1) an einer Verbindungsstelle jeweils wenigstens eine Öffnung (4) aufweisen, die deckungsgleich zueinander angeordnet sind,
dass beidseitig zu beiden Öffnungen (4) Bondelemente (7) vorgesehen sind, die derart gegeneinander verfügt sind, dass sie eine innige Bondverbindung bilden und die den Bondelementen jeweils zugewandten Umfangsränder der Öffnungen wenigstens teilweise umschließen.

10. Kontaktanordnung nach Anspruch 9,
**dadurch gekennzeichnet, dass** die Flexsubstrate (1) wenigstens eine elektrisch leitende Schicht (3) aufweist, die von wenigstens einer Öffnung (4) durchsetzt ist und den Umfangsrand der Öffnung (4) wenigstens teilweise umgibt, und dass die Bondverbindung eine elektrische Verbindung zwischen elektrisch leitenden Schichten (3) jeweils zweier getrennter, miteinander verbundener Flexsubstrate (1) herstellt.

11. Kontaktanordnung nach Anspruch 9 oder 10,
**dadurch gekennzeichnet, dass** die Flexsubstrate (1) eine Dicke von wenigen 10 µm und die Öffnungen (4) einen Durchmesser von ca. 50 µm aufweisen.

12. Kontaktanordnung nach einem der Ansprüche 9 bis 11,
**dadurch gekennzeichnet, dass** eine Vielzahl von unmittelbar übereinander verfügter Bondelemente vorgesehen ist, die eine Art turmartigen Kontaktfinger (9) bildet, die senkrecht über ein Flexsubstrat (1) emporragt.

13. Kontaktanordnung nach Anspruch 13,
**dadurch gekennzeichnet, dass** mehrere Kontaktfinger (9) auf einem Flexsubstrat (1) vorgesehen sind und als Elektroden oder als Abstandselemente zum Verfügen weiterer Flexsubstrate (1) gegenüber dem vorliegendem Flexsubstrat (1) dienen.

14. Kontaktanordnung nach einem der Ansprüche 9 bis 13,
**dadurch gekennzeichnet, dass** zumindest das zuletzt auf die Kontaktanordnung aufgebrachte Bondelement einstückig mit einem Bonddraht als Zuleitungsdraht (10) verbunden ist.

## Claims

1. A method for producing an electrical and/or mechanical connection between at least two flexible thin-film substrates, referred to as flexible substrates (1) hereinafter,
**wherein** said to-be-joined flexible substrates, which each have an opening (4) at the point of connection, are positioned in such a manner that said opening (4) of one flexible substrate is congruent with the opening (4) of another flexible substrate,
a bonding element (7) is positioned on both sides of each congruently aligned opening (4), and
both said bonding elements (7) are joined to a bonding connection by being pressed against each other and at least partially enclosing the peripheral edges of said openings (4) facing said bonding elements (7).

2. A method according to claim 1,
**wherein** said bonding elements are provided in the form of a bonding ball (7) by a bonding capillary (6) respectively by a ball-wedge bonder.

3. A method according to claim 1 or 2,
**wherein** a first bonding element (7) is placed on an ancillary substrate (5).

4. A method according to claim 3,
**wherein** said ancillary substrate (5) is heated and said bonding element (7) is pressed onto said ancillary substrate (5) and is deformed to a bond bump (8) while being fed ultrasonic energy.

5. A method according to claim 3 or 4,
**wherein** said congruently aligned openings (4) of said to-be-joined flexible substrates (1) are positioned above said first bonding element (7),
a second bonding element (7) is pressed through said opening (4) against said first bonding element (7) lying on said ancillary substrate (5) and joined while fed heat and ultrasonic energy and following the joining said ancillary substrate (5) is removed.

6. A method according to claim 5,
**wherein** before removal of said ancillary substrate (5) at least one further flexible substrate (1) is connected with the already joined flexible substrates (1) in that said opening (4) of said further flexible substrate (1) is positioned over said second bonding element (7) and is joined by means of a third bonding element (7) through said opening (4) of said other flexible substrate (1) against said second bonding element (7).

7. A method according to claim 6,
**wherein** the procedure for obtaining a towerlike arrangement (9), a so-called stack arrangement, is repeated by a plurality of joined flexible substrates (1).

8. A method according to one of the claims 1 to 7,
**wherein** electrically conductive layers (3) are provided in said flexible substrates (1),
in order to connect said electrically conductive layers (3) between two flexible substrates (1), said openings (4) are placed in said flexible substrates (1) in such a manner that said electrically conductive layers (3) end at the peripheral edges of said openings (4) in such a manner that the bonding connection produces an electrical contact between said electrical layers (3) of immediately adjacent flexible substrates (1) through said openings (4).

9. A contact arrangement between at least two flexible thin-film substrates, referred to as flexible substrates (1) hereinafter,
**wherein** said flexible substrates (1) are each provided with at least one opening (4) at a point of connection, which openings are arranged congruently at each other,
bonding elements (7) are provided on both sides of said two openings (4) and said bonding elements (7) are joined in such a manner that an intimate bonding connection is produced and that said bonding elements (7) at least partially enclose the peripheral edges of said openings facing said bonding elements respectively.

10. A contact arrangement according to claim 9,
**wherein** said flexible substrates (1) are provided with at least one electrically conductive layer (3) which has at least one opening (4) running through it and at least partially encloses said peripheral edge of said opening (4) and
said bonding connection produces an electrical connection between said electrically conductive layers (3) of two separate, joined flexible substrates (1).

11. A contact arrangement according to claim 9 or 10,
**wherein** said flexible substrates (1) have a thickness of a few 10µm and said openings (4) have a diameter of approximately 50µm.

12. A contact arrangement according to one of the claims 9 to 11,
**wherein** a plurality of bonding elements are provided, which are joined immediately stacked one on top of the other and which form a type of towerlike contact fingers (9) projecting vertically over a substrate (1).

13. A contact arrangement according to claim 13,
**wherein** a plurality of said contact fingers (9) are provided on a flexible substrate (1) and serve as electrodes or spacing elements for joining further flexible substrates (1) relative to said present flexible substrate (1).

14. A contact arrangement according to one of the claims 9 to 13,
**wherein** at least the bonding element last placed on said contact arrangement is connected one-piece to a bonding wire as a supply wire (10).

## Revendications

1. Procédé d'établissement d'une liaison électrique et/ou mécanique entre au moins deux substrats souples en film mince, appelés ci-après substrats souples (1),
**caractérisé en ce que** les substrats souples à relier, qui présentent respectivement au moins un orifice (4) à un point de liaison, sont positionnés de manière à ce que l'orifice (4) de l'un des substrats souples soit en recouvrement identique avec l'orifice (4) de l'autre substrat souple,
des deux côtés des orifices (4) orientés avec le même recouvrement, respectivement un élément de jonction (7) est positionné et
que les deux éléments de jonction (7) poussés par pression l'un contre l'autre, en enserrant du moins partiellement les bords circonférentiels tournés respectivement vers les éléments de jonction (7) des orifices (4), sont assemblés pour établir une liaison par jonction.

2. Procédé selon la revendication 1,
**caractérisé en ce que** les éléments de jonction se présentent sous forme d'une boule de jonction (7), d'un capillaire de jonction (6), par exemple d'une jonction à bordure en boule écrasée.

3. Procédé selon la revendication 1 ou 2,
**caractérisé en ce qu'**un premier élément de jonction (7) est appliqué sur un substrat auxiliaire (5).

4. Procédé selon la revendication 3,
**caractérisé en ce que** le substrat auxiliaire (5) est chauffé et l'élément de jonction (7) est comprimé sur le substrat auxiliaire (5) et est déformé sous apport d'énergie ultrasonore pour former une bosse de jonction (8).

5. Procédé selon la revendication 3 ou 4,
**caractérisé en ce que** les orifices (4) orientés les uns vers les autres avec le même recouvrement du substrat souple de liaison (1) sont positionnés au dessus du premier élément de jonction (7),
qu'un deuxième élément de jonction (7) est poussé de force à travers les orifices (4) contre le premier élément de jonction (7) reposant sur le substrat auxiliaire (5) et assemblé sous apport d'énergie thermique et ultrasonore et
après l'assemblage, le substrat auxiliaire (5) est enlevé.

6. Procédé selon la revendication 5,
**caractérisé en ce que**, avant d'enlever le substrat auxiliaire (5), au moins un autre substrat souple (1) est relié au substrat souple déjà assemblé (1) en positionnant l'orifice (4) de l'autre substrat souple (1) au dessus du deuxième élément de jonction (7) et en l'assemblant au moyen d'un troisième élément de jonction (7) à travers l'orifice (4) de l'autre substrat souple (1) au deuxième élément de jonction (7).

7. Procédé selon la revendication 6,
**caractérisé en ce que** le processus d'obtention d'une disposition semblable à une tour (9), une disposition dite en empilement, est répété par une multitude de substrats souples reliés entre eux (1).

8. Procédé selon une des revendications 1 à 7,
**caractérisé en ce que**, dans les substrats souples (1), des couches conductrices d'électricité (3) sont prévues,
pour relier les couches conductrices d'électricité (3) entre deux substrats souples (1), les orifices (4) sont pratiqués dans les substrats souples (1) de manière à ce que les couches conductrices d'électricité (3) se terminent au niveau des bords circonférentiels des orifices (4), de sorte que la liaison par jonction, à travers les orifices (4), établit un contact électrique entre les couches conductrices d'électricité (3) de substrats souples (1) immédiatement voisins.

9. Dispositif de contact entre au moins deux substrats souples en film mince, appelés ci-après substrats souples (1),
**caractérisé en ce que** les substrats souples (1) présentent respectivement à un point de liaison au moins un orifice (4) en recouvrement identique avec les autres orifices,
des deux côtés des deux orifices (4), il est prévu des éléments de jonction (7) qui sont assemblés les uns aux autres de manière à établir une liaison de jonction intime et qui enserrent du moins partiellement les bords circonférentiels tournés respectivement vers les éléments de jonction des orifices.

10. Dispositif de contact selon la revendication 9,
**caractérisé en ce que** les substrats souples (1) présentent au moins une couche conductrice d'électricité (3) qui est percée d'au moins un orifice (4) et enserre du moins partiellement le bord circonférentiel de l'orifice (4) et que la liaison de jonction établit une liaison électrique entre les couches conductrices d'électricité (3) de respectivement deux substrats souples séparés et reliés entre eux (1).

11. Dispositif de contact selon la revendication 9 ou 10,
**caractérisé en ce que** les substrats souples (1) ont une épaisseur d'au moins 10 µm et les orifices (4) un diamètre d'environ 50 µm.

12. Dispositif de contact selon une des revendications 9 à 11,
**caractérisé en ce qu'**il est prévu une multitude d'éléments de jonction disposés directement les uns au dessus des autres et formant un doigt de contact en forme de tour (9) qui dépasse verticalement d'un substrat souple (1).

13. Dispositif de contact selon la revendication 13,
**caractérisé en ce que** plusieurs doigts de contact (9) sont prévus sur un substrat souple (1) et servent d'électrodes ou d'éléments d'espacement pour assembler d'autres substrats souples (1) au substrat souple existant (1).

14. Dispositif de contact selon une des revendications 9 à 13,
**caractérisé en ce qu'**au moins l'élément de jonction disposé en dernier sur le dispositif de contact est relié en un bloc à un câble de jonction faisant office de câble d'alimentation (10).
